# EUROPEAN PATENT SPECIFICATION

(11) **EP 1 837 944 B1**
(45) Date of publication and mention of the grant of the patent: **23.04.2014**
(21) Application number: 07000120.1
(22) Date of filing: 04.01.2007
(51) Int. Cl.: H01M 10/052, H01M 10/30, H01M 10/34, H01M 10/44, H01M 10/46, H01M 10/48

(54) **Electric power supply control apparatus**
Vorrichtung zur Stromversorgungssteuerung
Appareil de contrôle d'alimentation électrique

(30) Priority: 24.03.2006 JP 2006081910
(43) Date of publication of application: 26.09.2007
(73) Proprietor: Hitachi, Ltd., Chiyoda-ku Tokyo 101-0022 (JP)
(72) Inventor: Jyou, Manabu c/o Hitachi Ltd, Chiyoda-ku Tokyo 100-8220 (JP); Emori, Akihiko c/o Hitachi Ltd, Chiyoda-ku Tokyo 100-8220 (JP); Kawahara, Youhei c/o Hitachi Ltd, Chiyoda-ku Tokyo 100-8220 (JP); Suzuki, Masato c/o Hitachi Ltd, Chiyoda-ku Tokyo 100-8220 (JP)
(74) Representative: Kirschner, Klaus Dieter

(56) References cited:
- EP-A2- 1 122 854
- WO-A1-2004/038439
- US-A1- 2001 011 883
- US-A1- 2005 073 315

## Description

The present invention relates to an electric power supply control apparatus which controls charge and discharge to and from an electric power supply comprising electrical storage means such as a lead acid cell, nickel-metal hydride cell or lithium ion cell.

Generally, secondary cells such as lead acid cells, nickel-metal hydride cells and lithium ion cells are mounted in electric cars and hybrid cars. Since nickel-metal hydride cells and lithium ion cells show higher energy density than lead acid cells, multi-serial/parallel arrangements of nickel-metal hydride or lithium ion cells are mainly used to drive vehicles. Especially in a large scale cell system needing high current, a plurality of cells are connected in a multi-parallel arrangement.

The secondary cell changes its state of charge (SOC) and state of health (state of health) as it is charged and discharged repeatedly. Usually, if a cell deteriorates, its internal resistance increases and its full charge capacity decreases. Since this lowers the total output of the system, it is necessary to disconnect deteriorated cells from the system or replace them by brand-new ones.

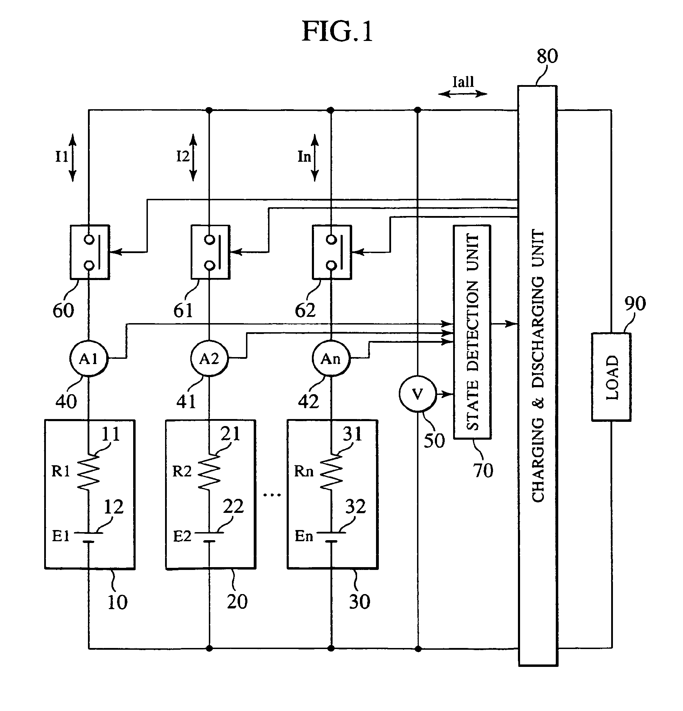

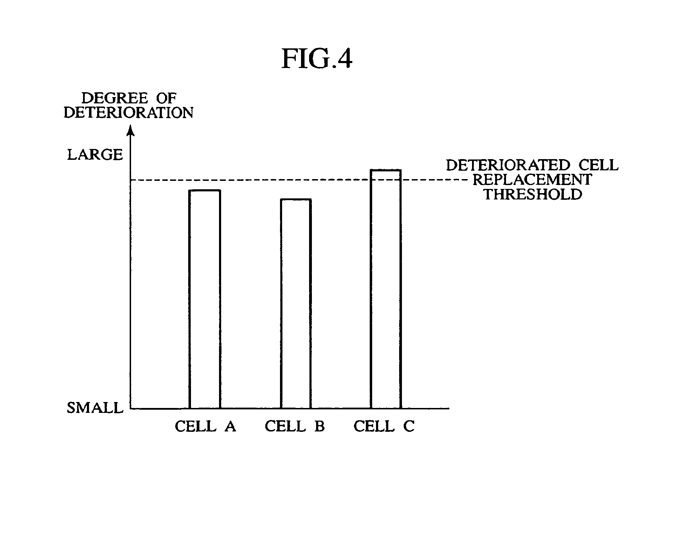

For example, in a prior art multi-parallel cell system described in Japanese Patent Laid-open No. 2001-185228 (Fig. 1, Fig. 4, paragraph (0007), paragraph (0008) and paragraph (0027)), if a deteriorated cell is detected, this cell is completely disconnected from the system.

Deterioration differs among the cells. If a certain cell deteriorates faster than the others in the prior art system, the deteriorated cell is completely disconnected from the parallel configuration. Therefore, the time when the system becomes impossible to supply a required amount of current will come earlier. This means the life as a cell system is shorter.

In addition, when a deteriorated cell is disconnected from the system and replaced by a brand-new one, the other cells may be not so deteriorated as to need to be replaced since deterioration differs among the cells. This increases the number of times replacement must be done, which lowers the maintainability.

WO 2004/038439 discloses a storage battery diagnosing system for diagnosing a storage battery used for an emergency power supply, a no-break power unit, an operating power supply and the like, the system comprising a current control unit connected between the terminals of a storage battery to be diagnosed, for controlling a discharge current required for diagnosing, a current detection unit for detecting and measuring a discharge current from the storage battery, a voltage detection unit for detecting and measuring a terminal voltage at the storage battery, and a main control unit having a voltage/current value storing unit for retaining current values and voltage values detected by the current detection unit and the voltage detection unit. The main control unit controls to allow the storage battery to discharge a current required for diagnosing for a short time so as to measure, a plurality of times and with an elapse of time, discharge currents from the storage battery at the discharging time and at points of time set after the discharging and respective terminal voltages at the discharging time and at a restoring time after the discharging.

According to US 2005/073315 A1, when a power switch portion is in an open state and a charge/discharge path of the secondary battery is in a disconnected state, an electromotive force calculation portion calculates a battery electromotive force Veq by subtracting a polarized voltage Vpol stored in a polarized voltage storage portion from an open-circuit voltage OCV measured by a voltage measurement portion. Based on the electromotive force, a state-of-charge estimation portion estimates a state of charge SOC. Thus, a polarized voltage to be considered for the estimation of SOC can be limited. The state of charge (SOC) of a secondary battery can be estimated with high accuracy and quickly.

The US 2001/011883 A1 provides a battery pack, using a battery comprising one or more cells as a power source and for connecting power to an external host device, and it comprises charging/discharging means connected in series to the battery and for performing charging and discharging, current detecting means for detecting charging and discharging current, voltage detecting means for detecting voltage, temperature detecting means for detecting temperature, and control means, whereby the control means is operated in such manner that it turns the state from at least one of charging state, discharging state, charging stop state, and discharging stop state to another state by controlling the charging/discharging means based on the charging/discharging current, the voltage and the temperature as detected,; and said state information is transmitted to the external host device when there is a request or at regular interval or when there is state transition, and state transition such as a charging/discharging state or a stop state of the battery pack controlled according to charging/discharging current, voltage, and temperature is controlled, and information of state transition can be managed and controlled by the external host device.

According to EP 1 122 854 A2, a power storage device has a plurality of series-connected storage battery units, battery circuits associated with the storage battery units to control or monitor the storage battery units, respectively; a main circuit of a potential level different from that of the battery circuits; and a potential level changing circuits connecting the battery circuit to the main circuit. The power storage unit is small in construction and operates at a low power consumption in a high control accuracy.

US 2004/0138785 discloses a power control apparatus for controlling charging and discharging of a plurality of storage means which has voltage measuring means for measuring voltages of said storage means respectively, current measuring means for measuring currents flowing through said storage means respectively, a status detecting means for detecting the operating status of each storage means from values measured by said voltage measuring means and said current measuring means, and a charging/discharging controlling means for controlling currents, voltages, or power according to the operating status of each storage means detected by said status detecting means to charge or discharge said storage means.

It is an object of the present invention to lengthen the life of a multi-parallel cell system and improve the maintainability thereof by keeping the constituent cells uniform in deterioration.

For this purpose, the electric power supply control apparatus of the invention which is connected in parallel to plural electric storage means, comprises the features of claim 1.

According to the present invention, it is possible to lengthen the total life and improve the maintainability of a multi-parallel secondary cell system by suppressing differences in the progress of deterioration among the secondary cells constituting the secondary cell system.

Preferred embodiments of the invention are characterized in the sub-claims.

Other objects and advantages of the invention will become apparent from the following description of embodiments with reference to the accompanying drawings in which:
Fig. 1 is a diagram to explain the general configuration of an electric power supply control apparatus according to a first embodiment;
Fig. 2 is a diagram to explain the principles of operation of the electric power supply control apparatus according to the first embodiment;
Fig. 3 is a diagram to explain the flows of operation of the electric power supply control apparatus according to the first embodiment;
Fig. 4 is a diagram to explain how electrical storage means deteriorate in the electric power supply control apparatus according to the first embodiment;
Fig. 5 is a diagram to explain the general configuration of an electric power supply control apparatus according to a second embodiment;
Fig. 6 is a diagram to explain the general configuration of an electric power supply control apparatus according to a third embodiment;
Fig. 7 is a diagram to explain the principles of operation of the prior art of the electric power supply control apparatus; and
Fig. 8 is a diagram to explain how electrical storage means deteriorate in the prior art of the electric power supply control apparatus.

### Detailed Description of the preferred Embodiments

Embodiments of the present invention will be described below in detail with reference to the drawings. Note that each of the components which are included in more than one embodiments is given the same reference numeral without redundant description.

### Embodiment 1

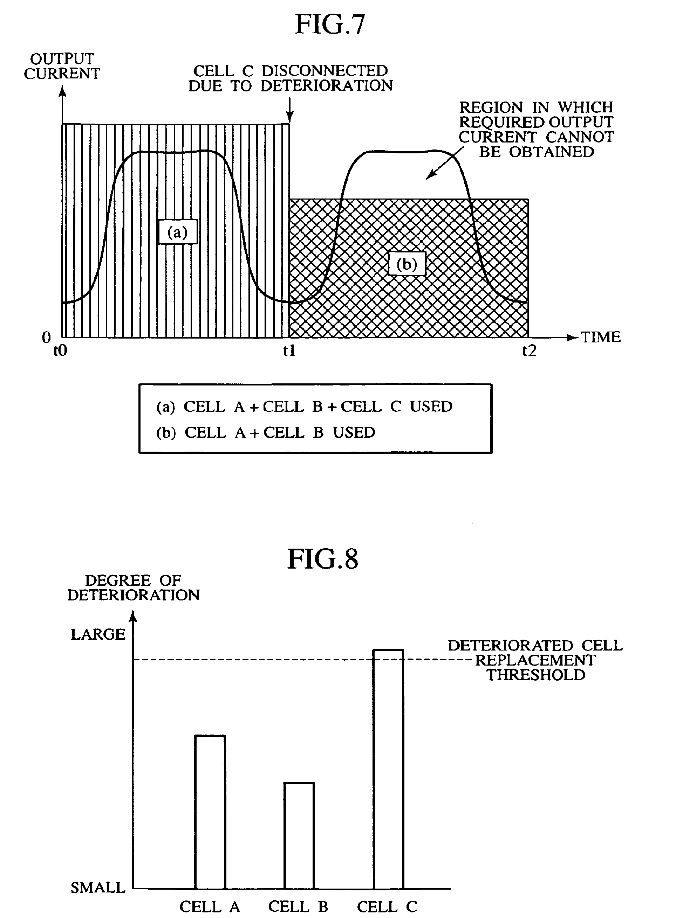

Fig. 1 shows the configuration of an electric power supply control apparatus according to the present embodiment. Prior to Fig. 1, the following describes the operation of the prior art electric power supply control apparatus for which the present invention was made as mentioned above. As shown in Fig. 7, if this electric power supply control apparatus detects a deteriorated cell, it disconnects the cell from the parallel arrangement.

The prior art electric power supply control apparatus of Fig. 7 has many secondary cells (hereinafter denoted simply as cells) connected in parallel via switches provided for the respective cells. Each switch can disconnect the corresponding cell. Here, description is given on the assumption that three cells, namely cell A, Cell B and cell C are connected in parallel. During the period of time t0 to time t1 ((a) in the figure), this electric power supply control apparatus obtains a required amount of output current by using the three cells or cell A, cell B and cell C. Then, at time t1, cell C is disconnected from the parallel configuration since cell C exceeds the deteriorated cell replacement threshold. During the period of time t1 to time t2 ((b) in the figure), a region occurs where a required amount of output current can not be obtained since only cells A and B are used as shown in Fig. 7.

Usually, since deterioration differs among the cells, the time when a required amount of output current becomes impossible to obtain comes earlier if a cell deteriorates faster than the others as mentioned above. In other words, this shortens the life of the total cell system. In addition, when a deteriorated cell is replaced by a brand-new one, the other cells may be not so deteriorated as to need to be replaced since deterioration differs among the cells. Therefore, it is not possible to replace all cells at a time, which may lower the maintainability.

Fig. 8 shows the state of health of each cell in the prior art electric power supply control apparatus shown in Fig. 7. Since deterioration differs among the cells, even when cell C exceeds the deteriorated cell replacement threshold, it is possible that cell A and cell B have not yet deteriorated substantially as shown in Fig. 8. It is therefore impossible to replace the deteriorated cell C together with cells A and B at a time, which lowers the maintainability.

In addition, disconnecting or replacing cell C which deteriorates faster shortens its life as a cell system since the period during which the effective output can be obtained is shortened.

Fig. 1 shows the configuration of the present electric power supply control apparatus embodiment. The electric power supply control apparatus of Fig. 1 comprises electrical storage units 10, 20 and 30, current measurement units 40, 41 and 42, voltage measurement unit 50, switching units 60, 61 and 62, state detection unit 70, charging and discharging unit 80 and a load 90. The electrical storage units 10, 20 and 30 respectively have internal resistances 11, 21 and 31 and open circuit voltages (electromotive forces) 12, 22 and 32.

The electrical storage unit 10 is connected in series to the current measurement unit 40 and the switching unit 60. Likewise, the electrical storage unit 20 is connected in series to the current measurement unit 41 and the switching unit 61 while the electrical storage unit 30 is connected in series to the current measurement unit 42 and the switching unit 62. These circuits, namely the one comprising the electrical storage unit 10, the current measurement unit 40 and the switching unit 60, the one comprising the electrical storage unit 20, the current measurement unit 41 and the switching unit 61 and the one comprising the electrical storage unit 30, the current measurement unit 42 and the switching unit 62 are mutually connected in parallel.

In addition, the circuit comprising the electrical storage unit 10, the current measurement unit 40 and the switching unit 60, the circuit comprising the electrical storage unit 20, the current measurement unit 41 and the switching unit 61 and the circuit comprising the electrical storage unit 30, the current measurement unit 42 and the switching unit 62 are all connected in parallel with the voltage measurement unit 50. As well, the circuit comprising the electrical storage unit 10, the current measurement unit 40 and the switching unit 60, the circuit comprising the electrical storage unit 20, the current measurement unit 41 and the switching unit 61 and the circuit comprising the electrical storage unit 30, the current measurement unit 42 and the switching unit 62 are all connected in parallel with the charging and discharging unit 80. The charging and discharging unit 80 is also connected to the load 90 which comprises a motor, electric generator, electronic equipment and the like. The voltage measured by the voltage measurement unit 50 is entered into the state detection unit 70. As well, the currents measured respectively by the current measurement unit 40, 41 and 42 are entered into the state detection unit 70. The currents, voltages and resistances calculated by the state detection unit 70 are entered into the charging and discharging unit 80. To measure the states of the electrical storage units 10, 20 and 30, such means as temperature measurement means may also be included although they are not shown in the figure.

The charging and discharging unit 80 performs calculation from the status values, for example, voltages, currents and resistances supplied from the state detection unit 70, and based on the result of calculation, controls the charging and discharging currents to and from the electric storage units 10, 20 and 30. The electric storage units 10, 20 and 30 of the present embodiment are rechargeable electric storage devices such as rechargeable lithium cells, nickel-metal hydride cells, lead acid cells, Ni-Cd cells, electric double layer capacitors or the like. Each of the electric storage units 10, 20 and 30 is composed of such an electric storage device or a plurality of such electric storage devices connected in parallel or in series. Each of the current measurement units 40, 41 and 42 comprises a current sensor such as a hall CT or shunt resistance type current sensor to measure the current which flows through the electric storage unit 10, 20 or 30. The voltage measurement unit 50 comprises voltage dividing resistors, an operational amplifier, A/D converter and other electronic parts to measure the voltage of the electrical storage units 10, 20 and 30. Each of the switching units 60, 61 and 62 comprises a relay and power semiconductor device to connect and disconnect the electrical storage unit 10, 20 or 30 to and from the parallel configuration. The state detection unit 70 comprises a microcomputer, peripheral IC and others to detect the states (voltages, currents and resistances) of the electrical storage units 10, 20 and 30 from the outputs of the current measurement units 40, 41 and 42 and voltage measurement unit 50. The charging and discharging unit 80 comprises a power transformer consisting of a converter, inverter, etc. to control the current, voltage and power which are to be supplied to or output from the electrical storage units 10, 20 and 30. In addition, the charging and discharging unit 80 judges the states of health of the electrical storage units 10, 20 and 30 from the status signal which is output from the state detection unit 70. Based on these states of health, the charging and discharging unit 80 controls switching of the switching units 60, 61 and 62.

The currents which respectively flow through the electrical storage units 10, 20 and 30 vary depending on their internal resistances 11, 21 and 31 and open circuit voltages (electromotive forces) 12, 22 and 32 and the input or output current, voltage, power and others of the charging and discharging unit 80. Thus, the state detection unit 70 detects the status quantities of internal resistances 11, 21 and 31 and of open circuit voltages (electromotive forces) 12, 22 and 32 of the electrical storage units 10, 20 and 30, and reports these status quantities to the charging and discharging unit 80. According to these status quantities, the charging and discharging unit 80 controls its input or output current, voltage and power and turns on and off the switching units 60, 61 and 62.

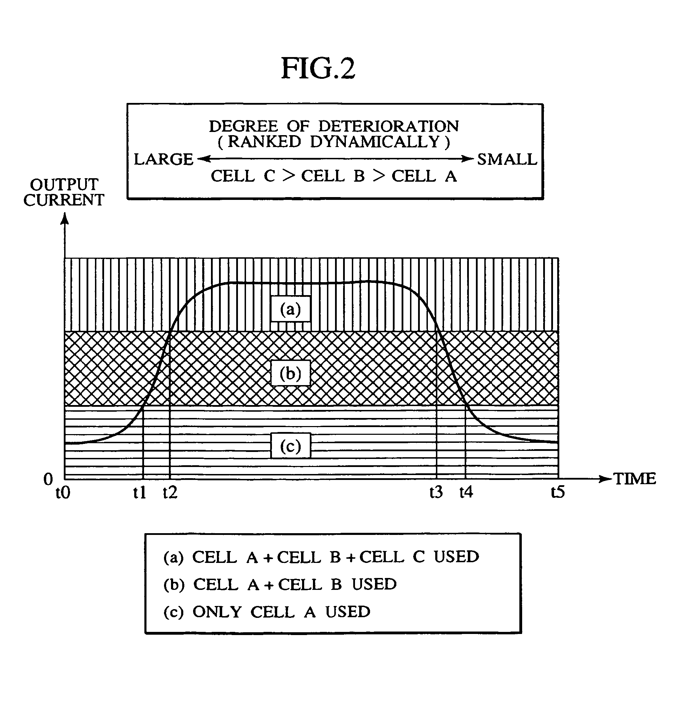

Fig. 2 illustrates how the electrical storage units 10, 20 and 30 are controlled by turning on and off the switching units 60, 61 and 62 shown in Fig. 1. As the electrical storage units 10, 20 and 30 deteriorate, their internal resistances 11, 21 and 31 increase and their full charge capacities decrease. From these changes due to deterioration in comparison with the initial conditions, their states of health (SOH) are determined. According to these states of health (SOH), the charging and discharging unit 80 dynamically ranks the degrees of deterioration of the electrical storage units 10, 20 and 30 connected mutually in parallel.

The following description is made on the assumption that the electrical storage units are three cells connected in parallel. In this example, deterioration of cell C is the largest while that of cell A is the smallest. Deterioration of cell B is intermediary between cell A and cell C.

During the period ((c) in Fig. 2) of time t0 to t1 in Fig. 2, since the output current can be supplied by one cell, only the least deteriorated cell A is discharged. During the period ((b) in Fig. 2) of time t1 to t2, since two cells are needed to supply the output current, the least deteriorated two cells A and B are discharged. During the period ((a) in Fig. 2) of time t2 to t3, since three cells are needed to supply the output current, all cells A, B and C are discharged. The t3-t4 period is similar to the t1-t2 period. As well, the t4-t5 period is similar to the t0-t1 period.

Discharging is performed as described above. When charging is performed, the switching units are turned on/off so that the charging priority is given in the increasing order of the state of charge (SOC). This makes the respective cells uniform in the state of charge (SOC).

As mentioned above, the respective cells are dynamically ranked in the degree of deterioration and the least deteriorated cells are selectively used so that all cells deteriorate uniformly. Since this prevents a certain cell from deteriorating faster and consequently lowering the output capacity of the cell system to below the required level, the life of the cell system can be made longer. In addition, since all cells deteriorate uniformly, all of them can be replaced at a time after deteriorated. This raises the maintainability. More preferably, the state of health of each cell is indicated to the external.

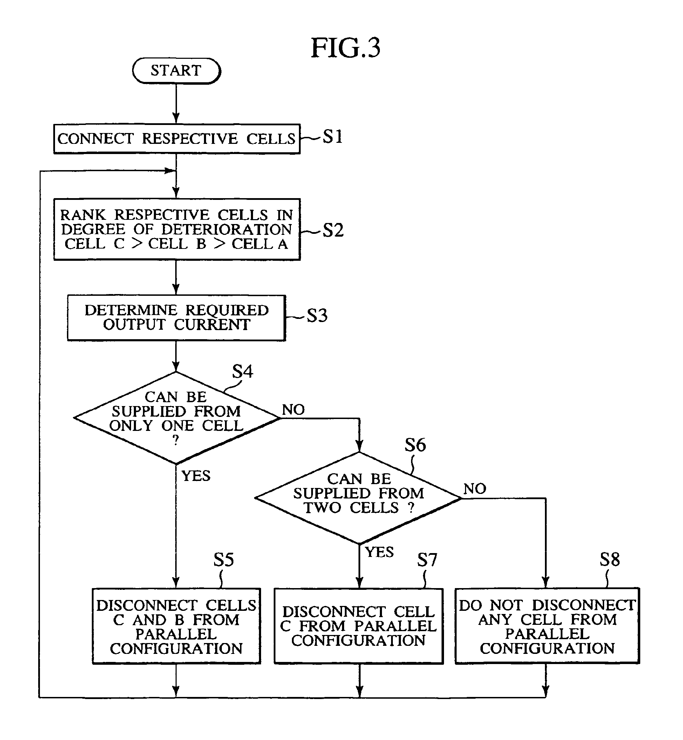

Provided in Fig. 3 is a process flow of carrying out the control method shown in Fig. 2. At first, in S1, the respective cells are connected in parallel. Then, in S2, the respective cells are dynamically ranked in the degree of deterioration. Then, in S3, the required output current is determined. Then, in S4, it is judged whether the output current can be supplied by only one cell. If possible, control goes to S5. If not, control goes to S6. In S5, the most deteriorated cells C and B are disconnected from the parallel configuration. In S6, it is judged whether the output current can be supplied by two cells. If possible, control goes to S7. If not possible, control goes to S8. In S7, only the most deteriorated cell C is disconnected from the parallel configuration. In S8, any cell is not disconnected from the parallel configuration since three cells are required to supply the output current. Then, control goes back to S2 to repeat the process.

Fig. 4 shows how the cells deteriorate as a result of the control method shown in Fig. 2. In this control method, all cells deteriorate uniformly. When cell C exceeds the deteriorated cell replacement threshold, cells A and B are about to reach the threshold. Therefore, the deteriorated cell C may be replaced together with cells A and B at a time. This means high maintainability.

In addition, since all cells deteriorate uniformly, all cells can be used until the deteriorated cell C is disconnected or replaced. This lengthens the period during which the effective output can be obtained, resulting in a longer life as the cell system.

The present embodiment has been described on the assumption that the electrical storage units 10, 20 and 30 are rechargeable electrical storage devices such as rechargeable lithium cells, nickel-metal hydride cells, lead acid cells, Ni-Cd cells, electric double layer capacitors or the like. Note that the electrical storage units 10, 20 and 30 may be fuel cells instead of such storage units. In this case, the charging and discharging unit 80 is replaced by discharging control means which performs discharging control according to the control flow of Fig. 3.

### Embodiment 2

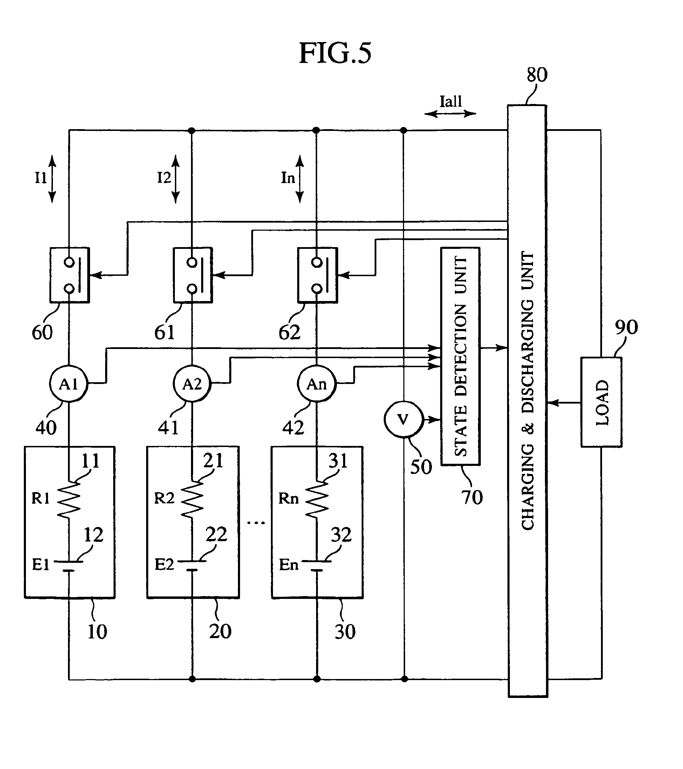

Fig. 5 shows the configuration of the electrical power supply control apparatus according to the present embodiment. The present embodiment is same as the first embodiment of Fig. 1 except that load 90 outputs a status signal to the charging and discharging unit 80. This status signal includes information such as the current expected to be required by the load 90 and the current velocity of the vehicle which the load 90 is driving. The charging and discharging unit 80 connects/disconnects the electrical storage units 10, 20 and 30 based on this status signal and their degrees of deterioration. Since the current to be required by the load 90 can be recognized, the charging and discharging unit 80 can connect/disconnect the electrical storage units 10, 20 and 30 in advance, which allows smooth supply of the output current.

### Embodiment 3

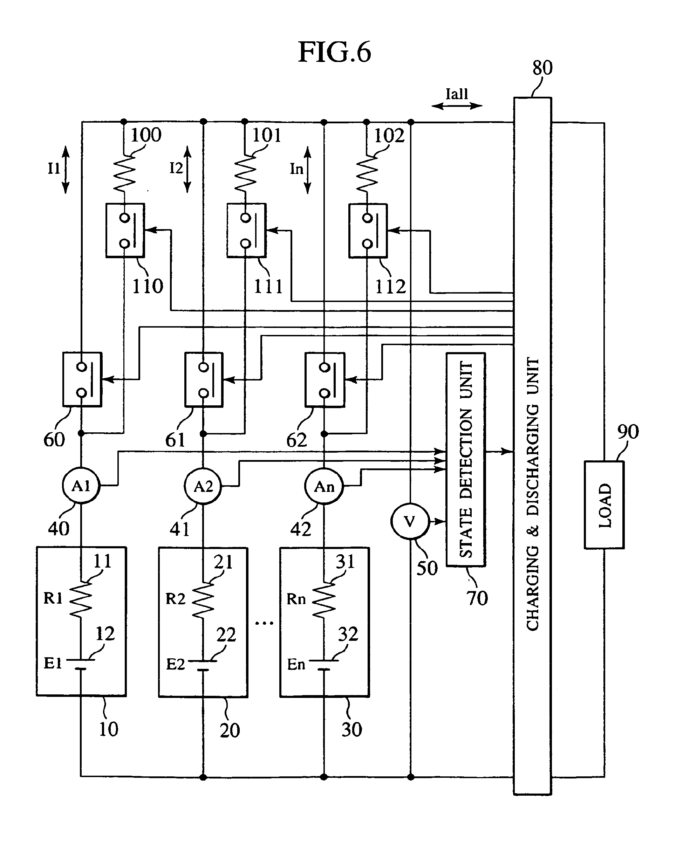

Fig. 6 shows the configuration of the electrical power supply control apparatus according to the present embodiment. The present embodiment is same as the first embodiment of Fig. 1 except that the circuit comprising a resistor 100 and a switch 110, the circuit comprising a resistor 101 and a switch 111 and the circuit comprising a resistor 102 and a switch 112 are respectively connected in parallel with the switching units 60, 61 and 62. These resistors 100, 101 and 102 prevent the switching units 60, 61 and 62 from causing large inrush current when they are turned on. For example, when turning on the switching unit 60 to use the electrical storage unit 10, the switch 110 is turned on in advance. This makes the electrical storage unit 10 free from large inrush current when the switching unit 60 is turned on.

While the invention has been described in its preferred embodiments, it is to be understood that the words which have been used are words of description rather than limitation and that changes within the purview of the appended claims may be made without departing from the true scope of the invention in its broader aspects.

## Claims

1. An electric power supply control apparatus which is connected in parallel to plural electric storage means (10, 20, 30), comprising:
plural current measurement means (40, 41, 42) which are configured to respectively measure the currents of the plural storage means (10, 20, 30) connected in parallel;
plural voltage measurement means (50) which are configured to respectively measure the voltages of the plural storage means (10, 20, 30) connected in parallel;
plural switching means (60, 61, 62) which are configured to respectively disconnect and connect the plural electric storage means (10, 20, 30) from and to the parallel connection;
state detection means (70) which are configured to receive the outputs of the current measurement means (40, 41, 42) and the outputs of the voltage measurement means (50) and to output the respective states of the plural electric storage means (10, 20, 30); and
charging and discharging means (80) which are configured to receive the outputs of the state detection means (70) and to charge and discharge the plural electric storage means (10, 20, 30) and to determine the deterioration states of the plural electric power storage means (10, 20, 30) from the outputs of the state detection means (70) to control switching of the plural switching means (60, 61, 62),
**characterized in that**
charging and discharging means (80) are further configured:
to rank the degrees of deterioration of the electric power storage means (10, 20, 30) connected in parallel, and
to receive also a status signal which is output from a load (90) which is indicative of the amount of current required by the load (90), and
to control switching of the plural switching means (60, 61, 62)
based on the judged respective deterioration states of the plural electric storage means (10, 20, 30), to control switching of the plural switching means (60, 61, 62) such that the electric storage means (10, 20, 30) to be charged or discharged are selected in the order of the least deteriorated one to the most deteriorated one, and
based on the status signal output from a load (90) to control switching of the plural switching means (60,61,62) such that the electric storage means (10, 20, 30)to be charged or discharged are controlled as required to supply the output current, and
wherein the charging and discharging means (80) are further configured to switch the switching of the plural switching means (60, 61, 62) dynamically.

2. The electric power supply control apparatus according to Claim 1, wherein each of the electric storage means (10, 20, 30) comprises a plurality of unit electric storage means connected in series.

3. The electric power supply control apparatus according to Claim 1, comprising means configured to indicate the deterioration states of the plural electric storage means (10, 20, 30) to the external.

4. The electric power supply control apparatus according to Claim 1, wherein each of the plural switching means (60, 61, 62) has a component connected in parallel thereto wherein the component comprises second switching means (110, 111, 112) and a resistor (100, 101, 102) connected in series to the second switching means (110, 111, 112).

## Patentansprüche

1. Elektrische Stromversorgungs-Steuervorrichtung, die parallel an einer Vielzahl von elektrischen Speichereinrichtungen (10, 20, 30) angeschlossen ist, umfassend:
eine Vielzahl von Strommesseinrichtungen (40, 41, 42), die konfiguriert sind, um die Ströme der Vielzahl der parallel geschalteten Speichereinrichtungen (10, 20, 30) respektive zu messen;
eine Vielzahl von Spannungsmesseinrichtungen (50), die konfiguriert sind, um die Spannungen der Vielzahl der parallel geschalteten Speichereinrichtungen (10, 20, 30) respektive zu messen,
eine Vielzahl von Schalteinrichtungen (60, 61, 62), die konfiguriert sind, um die Vielzahl der elektrischen Speichereinrichtungen (10, 20, 30) respektive zu trennen und zu verbinden von und zu der Parallelverbindung;
Statusdetektoreinrichtungen (70), die konfiguriert sind, um die Ausgänge der Strommesseinrichtungen (40, 41, 42) und die Ausgänge der Spannungsmesseinrichtungen (50) zu empfangen und die jeweiligen Zustände der Vielzahl der Speichereinrichtungen (10, 20, 30) auszugeben; und
Lade- und Entladeeinrichtungen (80), die konfiguriert sind, um die Ausgänge der Statusdetektoreinrichtungen (60) zu empfangen und die Vielzahl der elektrischen Speichereinrichtungen (10, 20, 30) zu laden und zu entladen und um die Verschlechterungszustände der Vielzahl der elektrischen Stromspeichereinrichtungen (10, 20, 30) von den Ausgängen der Statusdetektoreinrichtungen (70) zu bestimmen, um die Umschaltung der Vielzahl der Schalteinrichtungen (60, 61, 62) zu steuern,
**dadurch gekennzeichnet, dass**
die Lade- und Entladeeinrichtungen (80) ferner konfiguriert sind:
um das Maß der Verschlechterung der elektrischen parallel geschalteten Stromspeichereinrichtungen (10, 20, 30) in eine Rangordnung zu bringen und
auch ein Statussignal zu empfangen, welches von einer Last (90) ausgegeben wird, das eine Anzeige für die Menge des von der Last (90) geforderten Stromes anzeigt, und
die Umschaltung der Vielzahl der Schalteinrichtungen (60, 61, 62) zu steuern basierend auf den eingeschätzten jeweiligen Verschlechterungszuständen der Vielzahl der elektrischen Speichereinrichtungen (10, 20, 30), um die Umschaltung der Vielzahl der Schalteinrichtungen (60, 61, 62) so zu steuern, dass die elektrischen Speichereinrichtungen (10, 20, 30), die geladen oder entladen werden sollen, in der Reihenfolge von der am wenigsten verschlechterten zu der am meisten verschlechterten ausgewählt werden, und
basierend auf dem Statussignal, das von der Last (90) ausgegeben wird, um die Umschaltung der Vielzahl der Schalteinrichtungen (60, 61, 62) so zu steuern, dass die elektrischen Speichereinrichtungen (10, 20, 30), die geladen oder entladen werden sollen, so gesteuert werden, wie es zur Lieferung des Ausgangsstroms erforderlich ist, und
worin die Lade- und Entladeeinrichtung (80) ferner konfigurier ist, die Umschaltung der Vielzahl der Schalteinrichtungen (60, 61, 62) dynamisch umzuschalten.

2. Elektrische Stromversorgungs-Steuervorrichtung nach Anspruch 1, worin jede der elektrischen Speichereinrichtungen (10, 20, 30) eine Vielzahl von elektrischen Einheits-Speichereinrichtungen umfasst, die in Reihe geschaltet sind.

3. Elektrische Stromversorgungs-Steuervorrichtung nach Anspruch 1, umfassend Einrichtungen, die konfiguriert sind, um die Verschlechterungszustände der Vielzahl der elektrischen Speichereinrichtungen (10, 20, 30) extern anzuzeigen.

4. Elektrische Stromversorgungs-Steuervorrichtung nach Anspruch 1, worin jede der Vielzahl der Schalteinrichtungen (60, 61, 62) eine Komponente aufweist, die parallel dazu angeschlossen ist, wobei die Komponente zweite Schalteinrichtungen (110, 111, 112) und einen Widerstand (100, 101, 102) aufweist, der in Reihe mit den zweiten Umschalteinrichtungen (110, 111, 112) angeschlossen ist.

## Revendications

1. Appareil de contrôle d'alimentation électrique qui est connecté en parallèle à la pluralité de moyens de stockage électriques (10, 20, 30) comprenant:
- la pluralité de moyens de mesure de courant (40, 41, 42) qui sont configurés pour mesurer respectivement les courants de la pluralité de moyens de stockage (10, 20, 30) connectés en parallèle;
- la pluralité de moyens de mesure de la tension (50) qui sont configurés pour mesurer respectivement les tensions de la pluralité de moyens de stockage (10, 20, 30) connectés en parallèle;
- la pluralité de moyens de commutation (60, 61, 62) qui sont configurés pour déconnecter et respectivement connecter la pluralité de moyens de stockage électriques (10, 20, 30) de et à la connexion en parallèle;
- les moyens de détection d'état (70) qui sont configurés pour recevoir les sorties des moyens de mesure de courant (40, 41, 42) et les sorties des moyens de mesure de tension (50) et pour faire sortir les états respectifs de la pluralité de moyens de stockage électriques (10, 20, 30); et
- les moyens de chargement et de déchargement (80) qui sont configurés pour recevoir les sorties des moyens de détection d'état (70) et pour charger et décharger la pluralité de moyens de stockage électriques (10, 20, 30) et pour déterminer les états de détérioration de la pluralité de moyens de stockage électriques (10, 20, 30) à partir des sorties des moyens de détection d'état (70) pour commander la commutation de la pluralité de moyens de commutation (60, 61, 62),
**caractérisé en ce que**
- les moyens de chargement et déchargement (80) sont de plus configurés:
- pour classer les degrés de détérioration des moyens de stockage électriques (10, 20, 30) connectés en parallèle, et
- pour recevoir aussi un signal d'état qui est sorti d'une charge (90) qui est indicative de la quantité de courant exigé par la charge (90), et
- pour commander la commutation de la pluralité de moyens de commutation (60, 61, 62),
- basée sur les états de détérioration respectifs analysés de la pluralité de moyens de stockage électriques (10, 20, 30), pour commander la commutation de la pluralité de moyens de commutation (60, 61, 62) de sorte que les moyens de stockage électriques (10, 20, 30) pour être chargés ou déchargés soient sélectés dans l'ordre d'un moins détérioré à l'un le plus détérioré, et
- basée sur le signal d'état sorti d'une charge (90) pour commander la commutation de la pluralité de moyens de commutation (60, 61, 62) de sorte que les moyens de stockage électriques (10, 20, 30) pour être chargés ou déchargés soient commandés selon les besoins pour fournir le courant de sortie, et
- où les moyens de chargement et de déchargement (80) sont de plus configurés pour faire la commutation de la pluralité de moyens de commutation (60, 61, 62) de manière dynamique.

2. Appareil de contrôle d'alimentation électrique selon la revendication 1, où chacun d'entre les moyens de stockage électriques (10, 20, 30) comprend une pluralité de moyens de stockage électriques unitaires connectés en série.

3. Appareil de contrôle d'alimentation électrique selon la revendication 1, comprenant les moyens configurés pour indiquer les états de détérioration de la pluralité de moyens de stockage électriques (10, 20, 30) à l'extérieur.

4. Appareil de contrôle d'alimentation électrique selon la revendication 1, où chacun de la pluralité de moyens de commutation (60, 61, 62) présente une composante connectée y en parallèle où la composante comprend le second moyen de commutation (110, 111, 112) et une résistance (100, 101, 102) connectée en série au second moyen de commutation (110, 111, 112).
